# EUROPÄISCHE PATENTSCHRIFT

(11) **EP 1 224 736 B1**
(45) Veröffentlichungstag und Bekanntmachung des Hinweises auf die Patenterteilung: **25.08.2004**
(21) Anmeldenummer: 01985783.8
(22) Anmeldetag: 28.09.2001
(51) Int. Cl.: H03K 19/0185, H04L 25/02

(54) **GEGENTAKTENDSTUFE FÜR DIGITALE SIGNALE MIT GEREGELTEN AUSGANGSPEGELN**
PUSH-PULL END STAGE FOR DIGITAL SIGNALS WITH CONTROLLED OUTPUT LEVELS
ETAGE FINAL SYMETRIQUE A NIVEAUX DE SORTIE REGLES DESTINE AUX SIGNAUX NUMERIQUES

(30) Priorität: 29.09.2000 DE 10049774
(43) Veröffentlichungstag der Anmeldung: 24.07.2002
(73) Patentinhaber: Infineon Technologies AG, 81669 München (DE)
(72) Erfinder: HOEHN, Johann, 10967 Berlin (DE); SCHROEDINGER, Karl, 14089 Berlin (DE)
(74) Vertreter: Müller, Wolfram Hubertus, Dipl.-Phys.
(86) Internationale Anmeldenummer: PCT/DE2001/003799
(87) Internationale Veröffentlichungsnummer: WO 2002/027933

(56) Entgegenhaltungen:
- DE-A- 19 820 248
- US-A- 6 087 885
- US-A- 6 111 431
- US-A- 6 114 898

## Beschreibung

Bezeichnung der Erfindung: Gegentaktendstufe für digitale Signale mit geregelten Ausgangspegeln.

Die Erfindung betrifft eine Schaltung mit einer als Verstärkerstufe für digitale Signale wirkenden Gegentaktendstufe mit jeweils zwei als Sourcefolger arbeitenden n-Kanal MOS-Transistoren und ebenfalls als Sourcefolger arbeitenden p-Kanal MOS-Transistoren.

Gegentaktendstufen der eingangs genannten Art sind im Stand der Technik bekannt, vgl. US-A-6 114 898. Sie weisen generell den Nachteil auf, dass der Schwankungsbereich der Pegel verstärkter digitaler Signale aufgrund von Temperaturschwankungen, Spannungsschwankungen der Versorgungs-Stromquelle sowie von individuellen Fertigungs-Toleranzen der einzelnen elekronischen Baukomponenten so hoch ist, dass die Ausgangssignale dieser Schaltungen nicht als Eingangssignale für diverse andere Schaltungen verwendbar sind, so dass die Applikatonsmöglichkeiten der herkömmlichen Verstärkerschaltungen in der Praxis begrenzt sind.

Der Erfindung liegt deshalb die Aufgabe zugrunde, eine Schaltung mit einer Gegentaktendstufe für digitale Signale zu schaffen, bei der die Pegel der Ausgangssignale innerhalb eines begrenzten bzw. regelbaren und insofern fest vorgebbaren Schwankungsbereiches liegen, d.h. es soll eine Verstärkungsschaltung für digitale Signale geschaffen werden, bei der die Toleranz der Niveaus der Ausgangspegel (high für einen hohen Pegel bzw. low für einen niedrigen Pegel) möglichst gering gehalten ist.

Diese Aufgabe wird erfindungsgemäß durch eine Schaltung mit den Merkmalen des Anspruchs 1 gelöst. Bevorzugte und vorteilhafte Ausgestaltungen der Erfindung sind in den abhängigen Ansprüchen angegeben.

Danach ist erfindungsgemäß vorgesehen, daß die Gate-Anschlüsse der n-Kanal MOS-Transistoren und p-Kanal MOS-Transistoren jeweils von einem Operationsverstärker über Treiber angesteuert sind, wobei an dem nicht-invertierten Eingang des einen der Operationsverstärker eine Spannung anliegt, die den Sollwert des High-Pegels des Ausgangs der Gegentaktendstufe festlegt, und an dem nicht-invertierten Eingang des anderen der Operationsverstärker eine Spannung anliegt, die den Sollwert des Low-Pegels des Ausgangs der Gegentaktendstufe festlegt, und wobei die Operationsverstärker derart mit Rückkopplungsmitteln zusammenwirken, daß die High-Pegel oder Low-Pegel der Gate-Spannungen der n-Kanal und p-Kanal Transistoren unabhängig vom Betriebszustand der Gegentaktendstufe auf einen im wesentlichen konstanten Wert geregelt werden.

Die erfindungsgemäße Schaltung bewirkt, daß an den Gate-Anschlüssen der Transistoren der Endstufe vorgebbare, auf einen im wesentlichen konstanten Wert geregelte Spannungen anliegen, so daß auch die Pegel der Ausgangssignale innerhalb eines regelbaren und fest vorgebbaren Schwankungsbereiches liegen.

Bevorzugt wirken die jeweiligen Operationsverstärker dabei mit einer Netzwerkschaltung zusammen, die einen High-Pegel Knoten, der zur Rückkopplung mit dem invertierten Eingang des einen Operationsverstärkers verbunden ist und einen Low-Pegel-Knoten aufweist, der zur Rückkopplung mit dem invertierten Eingang des anderen Differenzverstärkers verbunden ist. Die Netzwerkschaltung ist bevorzugt eine Spiegelschaltung zur Endstufe mit einem n-Kanal MOS Transistor, einem p-Kanal MOS Transistor und einem dazwischen angeordneten Widerstand, wobei der High-Pegel Knoten und der Low-Pegel-Knoten an den beiden Anschlüssen des Widerstands anliegen.

Dabei weisen die Transistoren der Spiegelschaltung in einer Ausführungsform die gleiche Größe auf wie die n-Kanal Transistoren bzw. p-Kanal Transistoren der Gegentaktendstufe und ist der Widerstand der Spiegelschaltung gleich dem Lastwiderstand der Gegentaktendstufe. Es besteht somit vollständige Symmetrie zu der Endstufe.

Es liegt jedoch ebenfalls im Rahmen der Erfindung, daß die Transistoren der Spiegelschaltung sich um einen Faktor 1/n von den n-Kanal Transistoren bzw. p-Kanal Transistoren der Gegentaktendstufe unterscheiden, wobei der Widerstand der Spiegelschaltung sich dann um den Faktor n von dem Lastwiderstand der Gegentaktendstufe unterscheidet, so daß sich die Eigenschaften der Spiegelschaltung insgesamt nicht ändern. n ist dabei bevorzugt eine natürliche Zahl. Der Vorteil dieser Variante besteht darin, daß bei kleineren Transistoren und entsprechend größerem Widerstand die Stromaufnahme der Spiegelschaltung reduziert wird.

Bei zu der Ausgangsstufe symmetrischer Spiegelschaltung ist der High-Pegel des Ausgangs der Gegentaktendstufe gleich der Spannung, die an dem nicht-invertierten Eingang des einen der Operationsverstärker anliegt, und der Low-Pegel des Ausgangs der Gegentaktendstufe gleich der Spannung, die an dem nicht-invertierten Eingang des anderen der Operationsverstärker anliegt. Die Referenzspannungen an den Operationsverstärkern bilden somit den Sollwert für den High-Pegel und den Low-Pegel der Ausgangsspannung der Gegentaktendstufe.

Der Gegentaktendstufe sind zwei Treiber vorgeschaltet, die die Transistoren der Gegentaktendstufe ein- und ausschalten. Die Treiberstufen dienen dazu, die entsprechend benötigten Pegel V_{GHigh} und V_{Glow} für die Gate-Spannungen bereitzustellen, damit die Endstufe die richtigen Ausgangspegel erzeugt. Die Ausgangspegel Q, Qn hängen nur von den Pegeln V_{GHigh} und V_{Glow} ab.

Die erfindungsgemäße Schaltung wird im folgenden anhand einer bevorzugten Ausführungsform erläutert, die in den Figuren der Zeichnung dargestellt ist. Darin zeigen:
- Fig. 1: eine bevorzugte Ausführungsform der erfindungsgemäßen Schaltung in einem Übersichtsdiagramm;
- Fig. 2: die in Figur 1 dargestellte Ausführungsform der erfindungsgemäßen Schaltung in einem detaillierten Plan.

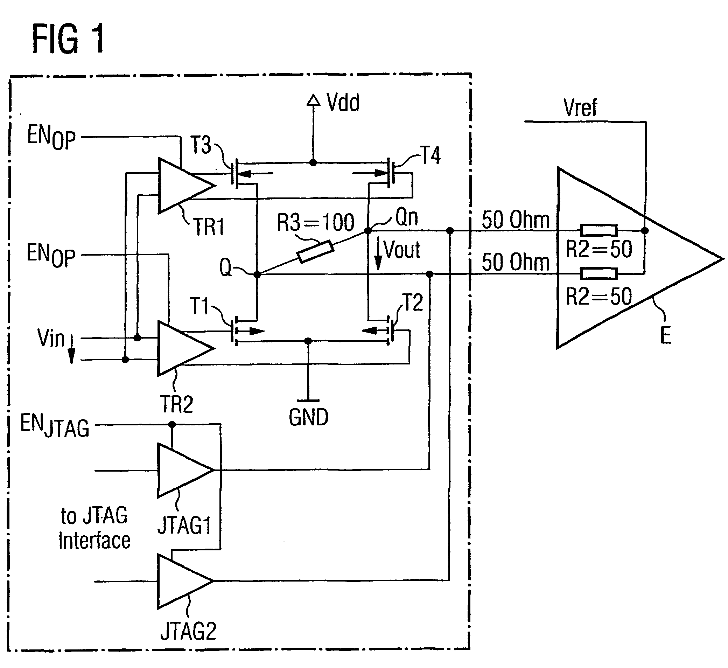

Figur 1 zeigt eine Endstufe mit zwei p-Kanal MOS Transistoren T1, T2 und zwei n-Kanal MOS Transistoren T3, T4. Die Transistoren T1 und T2 sowie T3 und T4 sind jeweils von der gleichen Größe und bilden die Gegentaktendstufe.

Sie stellen zwei gegeneinander arbeitetende, differentielle Verstärkerzweige dar (push-pull Verstärker). Die Drain-Anschlüsse der n-Kanal Transistoren T3, T4 sind mit der Betriebsspannung Vdd und die Drain-Anschlüsse der p-Kanal Transistoren T1, T2 mit Masse verbunden.

Zwischen den fest verkoppelten Source-Anschlüssen der Transistoren T3, T1 und den fest verkoppelten Source-Anchlüssen der Transistoren T4, T2 wird an den Bezugspunkten Q, Qn die Ausgangsspannung Vout abgenommen. Die Ausgänge Q, Qn sind über einen Widerstand R3 miteinander verbunden, an dem das Ausgangssignal abfällt.

Der Widerstand R3 ist optional und nur erforderlich, wenn die Ausgangsimpedanz unter Einbeziehung der Transistorimpedanz nicht ausreichend gut an die Leitung angepasst ist. Bevorzugt wird versucht, die Ausgangsimpedanz durch entsprechendes Design der Transistoren anzupassen, so daß der Widerstand R3 entfallen kann. Dadurch verringert sich die Stromaufnahme der Endstufe um den Faktor 2.

Alle vier Transistoren T1 bis T4 arbeiten als Sourcefolger. Es sind die jeweils über Kreuz liegenden Transistoren T1, T4 bzw. T2, T3 leitend und definieren über ihren Ausgangsspannungspegel (an den Bezugspunkten Q, Qn) den Strom durch den Widerstand R3 bzw. durch Lastwiderstände R2, R2' in einem sich anschließenden Schaltungsteil E. Die Lastwiederstände R2, R2' weisen dabei bevorzugt einen Widerstand von 50 Ohm auf, so daß sich ein Gesamt-Lastwiderstand vom 100 Ohm ergibt (als Abschlußwiderstand einer üblichen differenziellen 50 Ohm-Leitung).

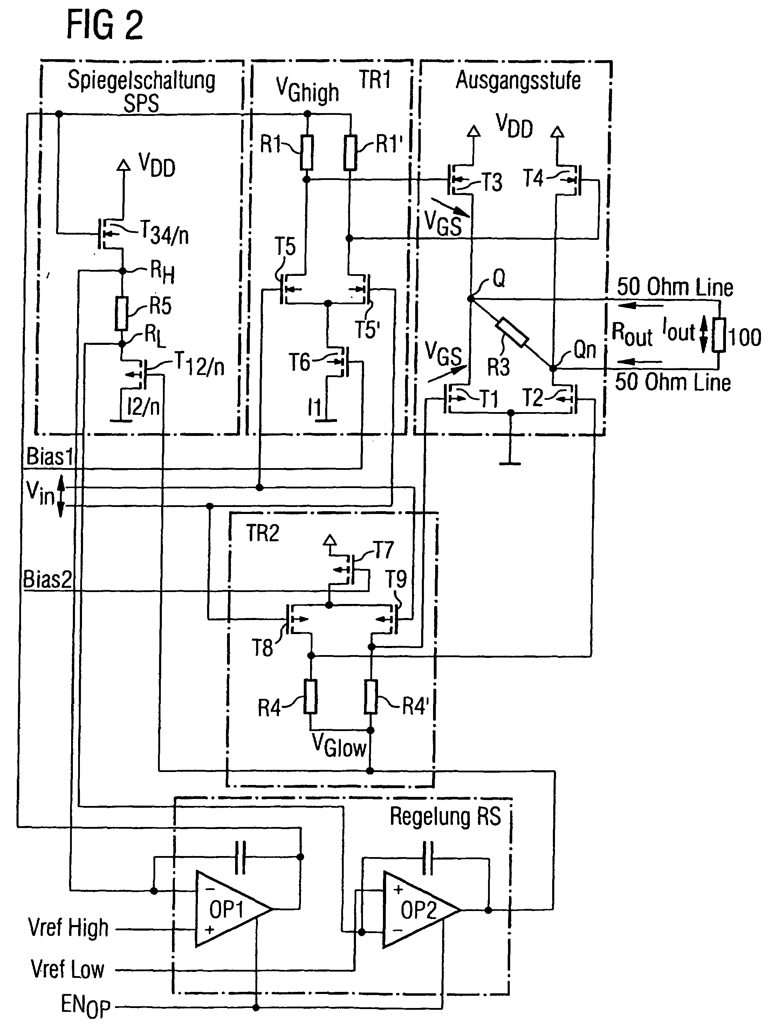

Zum Ein- und Ausschalten der Transistoren T1 bis T4 sind Treiber TR1, TR2 vorgesehen. Die Treiber TR1, TR2 bestimmen über den jeweiligen Pegel am Ausgang der Treiber bzw. am Gate der Transistoren T1 bis T4 das Sourcepotential. Die Treibervorstufen sowie eine zugeordnete Spannungs-Regelung sind in Figur 2 beschrieben, auf die im folgenden Bezug genommen wird.

Zuvor sei noch erwähnt, daß optional vorgesehen werden kann, durch einen Enabler-Steuereingang EN_{OP} die Treiber TR1, TR2 in einen Zustand zu schalten, in dem alle Transistoren T1 bis T4 gleichzeitig abgeschaltet sind. Dabei wird ein sogenannter (hochohmiger) Tristate-Zustand erreicht. In diesem Zustand ist es möglich, zu Testzwecken eine an sich bekannte Prüfschaltung (mit JTAG bezeichnet) an den Ausgang der Verstärkerstufe anzuschließen. Diese Schaltung wird über den Steuereingang EN_{JTAG} aktiviert.

Gemäß Figur 2 sind zwei Treiber TR1, TR2 zum Ein- und Ausschalten der Transistoren T1 bis T4 vorgesehen, wobei der Treiber TR1 die Transistoren T3, T4 und der Treiber TR2 die Transistoren T1, T2 treibt. Die Treiber TR1, TR2 sind jeweils als Differenzverstärker ausgebildet, wie im folgenden anhand der Treibers TR1 erläutert wird.

Der Treiber TR1 weist zwei n-Kanal MOS Transistoren T5, T5' auf, deren Gate-Anschlüsse mit der Eingangsspannung Vin verbunden sind. Ein weiterer n-Kanal MOS Transistor T6 ist an den gemeinsamen Source-Anschluß der Transistoren T5, T5' angeschlossen und dient als Stromquelle mit dem Strom I1. Am Gate-Anschluß des Transistors T6 liegt dabei eine Bias-Spannung Bias1 an, die den Stromfluß festlegt.

Der Drain-Anschluß des Transistors T5 ist über einen Widerstand R1 und der Drain-Anschluß des Transistors T5' über einen Widerstand R1' an eine Spannung V_{GHigh} angeschlossen, die über eine Spiegelschaltung zur Verfügung gestellt wird, wie noch erläutert werden wird. Dabei ist R1 gleich R1'.

Die beiden Transistoren T5, T5' bilden mit ihren Drain-Widerständen R1, R1' einen Differenzverstärker. Wird über die Eingangsspannung Vin an die Gate-Anschlüsse der Transistoren T5, T5' ein differentielles Logik-Signal angelegt, so liefert der Differenzverstärker TR1 ein Ausgangssignal mit entsprechend an die Tranistoren T3, T4 angepaßten Pegeln.

In entsprechender Weise ist der Treiber TR2 ein Differenzverstärker mit p-Kanal MOS Transistoren T7, T8, T9 und gleichen Widerständen R4, R4'. Die Wiederstände R4, R4' sind an eine Spannung V_{GLow} angeschlossen. Am Gate-Anschluß des Transistors T7 liegt eine Bias-Spannung Bias2 an.

Die Einstellung der Spannungen V_{GHigh} und V_{GLow} erfolgt über eine Spiegelschaltung SPS, die den Treibern TR1, TR2 vorgeschaltet ist. Die Spiegelschaltung SPS bildet die Ausgangsstufe nach und liefert in Zusammenwirkung mit zwei Operationsverstärkern OP1 und OP2 für die Gate-Spannungen ein geeignetes V_{GHigh} und V_{GLow}. Die Spiegelschaltung SPS umfaßt einen n-Kanal MOS Transistor T₃₄/n der vom gleichen Typ wie die Transistoren T3 und T4 ist, einen p-Kanal MOS Transistor T₁₂/n, der vom gleichen Typ wie die Transistoren T1 und T2 ist und einen Widerstand R5 von bevorzugt 100 Ohm * n, der dem Lastwiderstand R3 der Ausgangsstufe entspricht.

n ist dabei ein Skalierungsfaktor, der dazu dient, die Stromaufnahme in der Spiegelschaltung zu reduzieren, ohne die Eigenschaften der Spiegelschaltung zu ändern. So können die Transistoren T₁₂/n und T₃₄/n der Spiegelschaltung kleiner und der Widerstand R5 größer sein als die entsprechenden Teile der Endstufe, ohne daß sich die Eigenschaften insgesamt ändern.

Der Drain-Anschluß des Transistors T₃₄/n ist mit einem Versorgungsspannungspotential V_{DD} verbunden. Der Source-Anschluß des Transistors T₃₄/n ist mit einem Anschluß des Widerstandes R5 verbunden. Der andere Anschluß des Widerstandes R5 ist mit dem Source-Anschluß des Transistors T₁₂/n verbunden. Der Drain-Anschluß des Transistors T₁₂/n ist an Masse angelegt.

An den nicht-invertierenden Eingang des Operationsverstärkers OP1 wird eine Referenzspannung V_{ref High} für den Hochpegel angeschlossen. Der invertierende Eingang des Operationsverstärkers OP1 ist mit dem Source-Anschluß des Transistors T₃₄/n verbunden. Der Ausgang des Operationsverstärkers OP1 liegt an dem Gate-Anschluß des Transistors T₃₄/n und als V_{GHigh} an den beiden gleichwertigen Widerständen R1, R1' des Differenzverstärkers TR1 an. Der Source-Anschluß des Transistors T₁₂/n ist mit dem invertierenden Eingang des Operationsverstärkers OP2 verbunden, an dessen nicht-invertierendem Eingang die Referenzspannung für den Niedrig-Pegel V_{ref Low} angelegt ist. Der Ausgang dieses Operationsverstärkers OP2 ist mit dem Gate-Anschluß des Transistors T₁₂/n, der die Stromquelle I2/n bildet, verbunden. Weiter liegt der Ausgang des Operationsverstärkers OP2 als V_{GLow} an den beiden gleichwertigen Widerständen R4, R4' des Differenzverstärkers TR2 an.

Über eine optional vorgesehene Enabler-Leitung EN_{OP} können die Operationsverstärker OP1, OP2 derart geschaltet werden, daß die Transistoren T1 bis T4 der Endstufe gleichzeitig abgeschaltet sind, um an den Ausgang der Verstärkerstufe eine Prüfschaltung anzuschließen (vgl. Fig. 1).

Mit der in den Figuren 1 und 2 dargestellten Schaltung wird erreicht, dass an den Ausgängen Q und Qn ein digitales, differentielles Ausgangssignal anliegt, das für eine Datenübertragung mit einer hohen Datenrate geeignet ist und sich durch eine hohe Signalkonstanz bzw. Signalintegrität auszeichnet. Die hohe Signalintegrität wird erreicht, indem eine Anpassung der Ausgangsimpedanz der Ausgangstransistoren T1 bis T4 an die Impedanz der Übertragungsleitung, mit der der Ausgangstreiber verbunden sein muß, vorgenommen wird. Diese Anpassung erfolgt durch eine entsprechende Dimensionierung der Ausgangstransistoren T1 bis T4.

Die Funktionsweise der erfindungsgemäßen Schaltung ist dabei wie folgt:

In der Ausgangsstufe (Transistoren T1 bis T4) wird der differentielle High-Pegel (Spannung am Ausgang Q = V_{out High} und (gleichzeitig) Spannung am Ausgang Qn = V_{out Low}) erzeugt, wenn am Gate des NMOS-Transistors T3 die Steuerspannung V_{GHigh} anliegt und (gleichzeitig) am Gate des PMOS-Transistors T2 die Steuerspannung V_{GLow} anliegt.

Die Gate-Spannung des NMOS-Transistors T4 der Ausgangsstufe muß in diesem Betriebsfall so niedrig sein, daß T4 weitgehend ausgeschaltet ist und somit nahezu keinen Strom führt. Weiterhin muß die Gate-Spannung des PMOS-Transistor T1 in diesem Betriebszustand so hoch sein, daß T1 ausgeschaltet ist.

Zur weiteren Erläuterung des Gesamtschaltung wird der oben geschilderte Betriebsfall (differentieller High-Pegel am Ausgang) angenommen. Die Ausgangsstufe kann in diesem Fall gedanklich vereinfacht werden. Da die Ausgangs-Transistoren T1 und T4 stromlos sind und sie deshalb die Spannungen an den Ausgangskonten Q bzw. Qn nicht beeinflußen können, können sie gedanklich aus der Schaltung entfernt werden. Damit besteht die Ausgangsstufe nur noch aus den Transistoren T3 und T2, dem externen Lastwiderstand R2, R2' von 100 Ohm und dem optionalen Abschlußwiderstand R3. Die Ausgangsstufe entspricht somit genau der Spiegelschaltung.

Die Aufgabe der Spiegelschaltung besteht darin, die Gate-Spannungen V_{GHigh} und V_{GLow} zu erzeugen. Dazu werden zwei Regelkreise verwendet. Der erste Regelkreis besteht aus dem Operationsverstärker OP1 und dem Transistor T₃₄/n, der zweite Regelkreis aus dem Operationsverstärker OP2 und T_{12/n}. OP1 erzeugt eine Spannung am Gate des Transistors T₃₄/n, die sich aufgrund der Rückkoppelung so einstellt, daß die Eingangsdifferenz-Spannung von OP1 gegen Null Volt strebt. Damit wird am Source-Knoten von T₃₄/n eine Spannung eingestellt, die denselben Wert hat wie die Referenzspannung V_{ref High} am nicht invertierenden Eingang von OP1. OP2 stellt aufgrund seiner Rückkopplung ebenfalls eine Eingangsdifferenz-Spannung ein, die gegen Null Volt strebt, womit die Source-Spannung des PMOS-Transistors T₁₂/n den Wert V_{ref Low} annimmt. Die beiden Regelkreise erzeugen somit die Gate-Spannungen V_{GHigh} und V_{GLow}, die solche Werte annehmen, daß die Spannung am oberen Knoten Rₕ vom Widerstand R5 gleich V_{ref} _{High} ist und die Spannung am unteren Knoten R₁ vom Widerstand R5 gleich V_{ref Low} ist. Die von der Spiegelschaltung in Verbindung mit den beiden Regelkreisen erzeugten Gate-Spannungen V_{GHigh} bzw. V_{GLow} sind unabhängig vom Betriebszustand der Ausgangsstufe und unabhängig von den Betriebszuständen der Treiberstufen TR1 und TR2.

Die Aufgabe der Treiberstufe TR1 besteht darin, in Abhängigkeit von der Eingangsspannung Vin einen der beiden möglichen Betriebszustände der Ausgangstransistoren T3 und T4 einzustellen. Die möglichen Betriebszustände von T3 und T4 in der Ausgangsstufe ergeben sich dadurch, daß in der Treiberstufe TR1 der Strom I1 des als Stromquelle arbeitenden Transistors T6 entweder vollständig durch T5 geleitet wird (wenn das Gate von T5 mit einem High-Pegel angesteuert wird und gleichzeitig das Gate von T5' mit einem Low-Pegel angesteuert wird) oder vollständig durch T5' geleitet wird.

Wird der Strom 11 durch T5' geleitet, so entsteht an dem Widerstand R1', der mit dem Drain von T5' verbunden ist, ein Spannungsabfall I1*R1. Damit nimmt die Gate-Spannung von T4 der Ausgangsstufe den Wert V_{GHigh}-I1*R1 an. Durch die vorgabe der Größen 11 und R1' wird sichergestellt, daß T4 der Ausgangsstufe abgeschaltet ist, wenn der Strom I2 in der Treiberstufe durch T5' geleitet wird. In diesem Betriebszustand der Treiberstufe TR1 fließt kein Strom durch T5 des Treibers TR1, damit ergibt sich auch kein Spannungsabfall über dem Widerstand R1, der mit dem Drain von T5 verbunden ist. Aus diesem Grund wird die Gate-Spannung von T3 über den in Fig. 2 linken Widerstand R1 auf den Wert V_{GHigh} gezogen.

Die Treiberstufe TR2 stellt nach dem gleichen Prinzip wie das der Treiberstufe TR1 die Gate-Spannungen der Ausgangstransistoren T1 und T2 ein.

In dem oben betrachteten Fall, in dem die Gate-Spannung von T3 den Wert V_{GHigh} angenommen hat, stellt sich aufgrund der Eingangsspannung Vin in der Treiberstufe TR2 ein Zustand ein, bei dem die Gate-Spannung am PMOS-Ausgangstransistor T2 den Wert V_{GLow} angenommen hat und die Gate-Spannung des PMOS-Ausgangstransistors T1 so hoch liegt, daß dieser kein Strom führt. Da in der Spiegelschaltung nun die gleichen Gate-Spannungen an den Transistoren T₃₄/n und T₁₂/n anliegen wie an den Transistoren der Ausgangsstufe T3 und T2 und in der Spiegelschaltung ein äquivalentes Lastelement (Widerstand R5) vorhanden ist wie in der Ausgangsstufe, nämlich der Lastwiderstand von 100 Ohm und der optionale Abschlußwiderstand R3, stellt sich am Ausgang Q die Spannung V_{ref High} ein und am Ausgang Qn die Spannung V_{ref Low}. Dies entspricht einem differentiellen High-Signal am Ausgang der Schaltung.

Wenn nun die differentielle Eingangsspannung Vin ihr Vorzeichen wechselt, nimmt der Transistor T4 der Ausgangsstufe den Zustand ein, den vorher der Transistor T3 hatte und T3 nimmt den Zustand ein, den vorher T4 hatte. Eine entsprechende Vertauschung der Zustände findet auch bei den Ausgangstransistoren T1 und T2 statt. Die Ausgangsstufe wechselt damit insgesamt ihren Zustand von einem diferentiellen High-Signal am Ausgang in einen Zustand mit einem differentiellen Low-Signal am Ausgang.

Es erfolgt somit eine Einstellung der Gatespannung im High-Pegel bei den Transistoren T3 und T4 und eine Einstellung der Gatespannung im Low-Pegel bei den Transistoren T1 und T2. Geregelt wird der Arbeitspunkt in der Spiegelschaltung SPS, welche statisch betrieben wird.

Es wird darauf hingewiesen, daß in einer alternativen Schaltung die Transistoren T1, T2 und T₁₂/n als n-Kanal MOS Transistoren und die Transistoren T3, T4 und T₃₄/n als p-Kanal MOS Transistoren ausgebildet sein können. Die erläuterte Schaltung funktioniert dann in entsprechender Weise. Der Widerstand R3 bzw. der Lastwiderstand wird in diesem Fall durch die jeweiligen Drain-Anschlüsse angesteuert. Die Regelung gleicht auch in diesem Fall die Pegel an. Das Ausgangssignal Q ist invertiert (Q, Qn sind vertauscht).

Die oben erläuterten Ausführungsbeispiele der Erfindung dienen lediglich dem Zweck eines besseren Verständnisses der durch die Ansprüche vorgegebenen erfindungsgemäßen Lehre, die als solche durch die Ausführungsbeispiele nicht eingeschränkt ist.

## Patentansprüche

1. Schaltung mit einer als Verstärkerstufe für digitale Signale wirkenden Gegentaktendstufe mit jeweils zwei als Sourcefolger arbeitenden n-Kanal MOS-Transistoren und ebenfalls als Sourcefolger arbeitenden p-Kanal MOS-Transistoren,
**dadurch gekennzeichnet,**
**dass** die Gate-Anschlüsse der jeweiligen n-Kanal MOS-Transistoren (T3, T4) und p-Kanal MOS-Transistoren (T1, T2) jeweils von einem Operationsverstärker (OP1, OP2) über Treiber (TR1, TR2) angesteuert sind, wobei an dem nicht-invertierten Eingang des einen der Operationsverstärker (OP1) eine Spannung (V_{ref High}) anliegt, die den Sollwert des High-Pegels des Ausgangs der Gegentaktendstufe festlegt, und an dem nicht-invertierten Eingang des anderen der Operationsverstärker (OP2) eine Spannung (V_{ref Low}) anliegt, die den Sollwert des Low-Pegels des Ausgangs der Gegentaktendstufe festlegt, und wobei die Operationsverstärker (OP1, OP2) derart mit Rückkopplungsmitteln zusammenwirken, daß die High-Pegel oder Low-Pegel der Gate-Spannungen (V_{GHigh}, V_{GLow}) der n-Kanal und p-Kanal Transistoren (T1, T2, T3, T4) unabhängig vom Betriebszustand der Gegentaktendstufe auf einen im wesentlichen konstanten Wert geregelt werden.

2. Schaltung nach Anspruch 1, **dadurch gekennzeichnet, daß**
die jeweiligen Operationsverstärker (OP1, OP2) mit einer Netzwerkschaltung (SPS) zusammenwirken, die einen High-Pegel Knoten (Rₕ), der zur Rückkopplung mit dem invertierten Eingang des einen Operationsverstärkers (OP1) verbunden ist und einen Low-Pegel-Knoten (R₁) aufweist, der zur Rückkopplung mit dem invertierten Eingang des anderen Differenzverstärkers (OP2) verbunden ist.

3. Schaltung nach Anspruch 2, **dadurch gekennzeichnet, daß** die Netzwerkschaltung eine Spiegelschaltung zur Endstufe aufweist mit einem n-Kanal MOS Transistor (T₃₄/n), einem p-Kanal MOS Transistor (T₁₂/n) und einem dazwischen angeordneten Widerstand (R5), wobei der High-Pegel Knoten (Rₕ) und der Low-Pegel-Knoten (R₁) an den beiden Anschlüssen des Widerstands (R5) anliegen.

4. Schaltung nach Anspruch 3, **dadurch gekennzeichnet, daß** die Transistoren (T₃₄/n, T₁₂/n)der Spiegelschaltung die gleiche Größe aufweisen wie die n-Kanal Transistoren (T3, T4) bzw. p-Kanal Transistoren (T1, T2) der Gegentaktendstufe und der Widerstand (R5) der Spiegelschaltung gleich dem Lastwiderstand der Gegentaktendstufe ist.

5. Schaltung nach Anspruch 3, **dadurch gekennzeichnet, daß** die Transistoren (T₃₄/n, T₁₂/n) der Spiegelschaltung sich um einen Faktor 1/n von den n-Kanal Transistoren (T3, T4) bzw. p-Kanal Transistoren (T1, T2) der Gegentaktendstufe unterscheiden und der Widerstand (R5) der Spiegelschaltung sich um den Faktor n von dem Lastwiderstand der Gegentaktendstufe unterscheidet.

6. Schaltung nach mindestens einem der Ansprüche 3 bis 5,
**dadurch gekennzeichnet, daß**
der High-Pegel des Ausgangs der Gegentaktendstufe gleich der Spannung (V_{ref High}) ist, die an dem nicht-invertierten Eingang des einen der Operationsverstärker (OP1) anliegt, und der Low-Pegel des Ausgangs der Gegentaktendstufe gleich der Spannung (V_{ref Low}) ist, die an dem nicht-invertierten Eingang des anderen der Operationsverstärker (OP2) anliegt.

7. Schaltung nach mindestens einem der Ansprüche 2 bis 6, **dadurch gekennzeichnet, daß** die Treiber (TR1, TR2) der Gegentaktendstufe vorgeschaltet sind und die von den Operationsverstärkern (TR1, TR2) in Zusammenwirkung mit den Rückkopplungsmitteln zur Verfügung gestellten Gate-Spannungen (V_{GHigh}, V_{GLow}) oder davon abhängige Spannungen in Abhängigkeit von der Eingangsspannung (Vin) den Transistoren (T1, T2, T3, T4) der Gegentaktendstufe zur Verfügung stellen.

8. Schaltung nach mindestens einem der vorangehenden Ansprüche, **dadurch gekennzeichnet, daß** die Treiber (TR1, TR2) als Differenzverstärker ausgebildet sind.

9. Schaltung nach mindestens einem der vorangehenden Ansprüche, **dadurch gekennzeichnet, daß** zwischen die Ausgänge (Q, Qn) der Gegentaktendstufe ein Widerstand (R3) geschaltet ist.

## Claims

1. Circuit having a push-pull output stage - acting as amplifier stage for digital signals - having in each case two n-channel MOS transistors operating as source followers and p-channel MOS transistors likewise operating as source followers,
**characterized**
**in that** the gate terminals of the respective n-channel MOS transistors (T3, T4) and p-channel MOS transistors (T1, T2) are in each case driven by an operational amplifier (OP1, OP2) via drivers (TR1, TR2), a voltage (V_{ref High}) which defines the desired value of the high level of the output of the push-pull output stage being present at the noninverted input of one of the operational amplifiers (OP1), and a voltage (V_{ref Low}) which defines the desired value of the low level of the output of the push-pull output stage being present at the noninverted input of the other of the operational amplifiers (OP2), and the operational amplifiers (OP1, OP2) interacting with feedback means in such a way that the high levels or low levels of the gate voltages (V_{GHigh}, V_{GLow}) of the n-channel and p-channel transistors (T1, T2, T3, T4) are regulated to an essentially constant value independently of the operating state of the push-pull output stage.

2. Circuit according to Claim 1, **characterized in that** the respective operational amplifiers (OP1, OP2) interact with a network circuit (SPS) having a high level node (Rₕ), which is connected for feedback to the inverted input of one operational amplifier (OP1), and a low level node (R₁), which is connected for feedback to the inverted input of the other differential amplifier (OP2).

3. Circuit according to Claim 2, **characterized in that** the network circuit has a mirror circuit with respect to the output stage, having an n-channel MOS transistor (T₃₄/n), a p-channel MOS transistor (T₁₂/n) and a resistor (R5) arranged in between, the high level node (Rₕ) and the low level node (R₁) being present at the two terminals of the resistor (R5).

4. Circuit according to Claim 3, **characterized in that** the transistors (T₃₄/n, T₁₂/n) of the mirror circuit have the same size as the n-channel transistors (T3, T4) and p-channel transistors (T1, T2) of the push-pull output stage and the resistor (R5) of the mirror circuit is equal to the load resistance of the push-pull output stage.

5. Circuit according to Claim 3, **characterized in that** the transistors (T₃₄/n, T₁₂/n) of the mirror circuit differ by a factor 1/n from the n-channel transistors (T3, T4) and p-channel transistors (T1, T2) of the push-pull output stage and the resistor (R5) of the mirror circuit differs by the factor n from the load resistance of the push-pull output stage.

6. Circuit according to at least one of Claims 3 to 5, **characterized in that**
the high level of the output of the push-pull output stage is equal to the voltage (V_{ref} High) present at the noninverted input of one of the operational amplifiers (OP1), and the low level of the output of the push-pull output stage is equal to the voltage (V_{ref Low}) present at the noninverted input of the other of the operational amplifiers (OP2).

7. Circuit according to at least one of Claims 2 to 6, **characterized in that** the drivers (TR1, TR2) are connected upstream of the push-pull output stage and the gate voltages (V_{GHigh}, V_{GLow}) made available by the operational amplifiers (TR1, TR2) in interaction with the feedback means or voltages dependent thereon are available to the transistors (T1, T2, T3, T4) of the push-pull output stage in a manner dependent on the input voltage (Vin).

8. Circuit according to at least one of the preceding claims, **characterized in that** the drivers (TR1, TR2) are designed as differential amplifiers.

9. Circuit according to at least one of the preceding claims, **characterized in that** a resistor (R3) is connected between the outputs (Q, Qn) of the push-pull output stage.

## Revendications

1. Circuit ayant un étage final symétrique faisant office d'étage amplificateur pour signaux numériques et comportant respectivement deux transistors MOS à canal n travaillant comme source-suiveur et deux transistors MOS à canal p travaillant également comme source-suiveur,
**caractérisé par le fait que** les bornes de grille des transistors MOS à canal n (T3, T4) respectifs et des transistors MOS à canal p (T1, T2) respectifs sont commandées à chaque fois par un amplificateur opérationnel (OP1, OP2) par l'intermédiaire d'un élément d'attaque (TR1, TR2), une tension (V_{ref High}) qui fixe la valeur de consigne du niveau haut de la sortie de l'étage final symétrique étant appliquée à l'entrée non inversée de l'un des amplificateurs opérationnels (OP1), une tension (V_{ref Low}) qui fixe la valeur de consigne du niveau bas de la sortie de l'étage final symétrique étant appliquée à l'entrée non inversée de l'autre amplificateur opérationnel (OP2) et les amplificateurs opérationnels (OP1, OP2) coopérant de telle sorte avec des moyens de rétroaction que les niveaux haut ou bas des tensions de grille (V_{GHigh}, V_{GLow}) des transistors à canal n et à canal p (T1, T2, T3, T4) sont réglés indépendamment de l'état de fonctionnement de l'étage final symétrique sur une valeur sensiblement constante.

2. Circuit selon la revendication 1, **caractérisé par le fait que** les amplificateurs opérationnels (OP1, OP2) respectifs coopèrent avec un circuit en réseau (SPS) qui comporte un noeud de niveau haut (Rₕ) qui est relié pour la rétroaction à l'entrée inversée de l'amplificateur opérationnel (OP1) et un noeud de niveau bas (Rₗ) qui est relié pour la rétroaction à l'entrée inversée de l'autre amplificateur opérationnel (OP2).

3. Circuit selon la revendication 2, **caractérisé par le fait que** le circuit en réseau comporte un circuit miroir de l'étage final avec un transistor MOS à canal n (T₃₄/n), avec un transistor MOS à canal p (T₁₂/n) et avec une résistance (R5) montée entre, le noeud de niveau haut (Rₕ) et le noeud de niveau bas (Rₗ) se trouvant aux deux bornes de la résistance (R5).

4. Circuit selon la revendication 3, **caractérisé par le fait que** les transistors (T₃₄/n, T₁₂/n) du circuit miroir ont la même dimension que les transistors à canal n (T3, T4) respectivement que les transistors à canal p (T1, T2) de l'étage final symétrique et que la résistance (R5) du circuit miroir est égale à la résistance de charge de l'étage final symétrique.

5. Circuit selon la revendication 3, **caractérisé par le fait que** les transistors (T₃₄/n, T₁₂/n) du circuit miroir se distinguent d'un facteur 1/n des transistors à canal n (T3, T4) respectivement des transistors à canal p (T1, T2) de l'étage final symétrique et que la résistance (R5) du circuit miroir se distingue du facteur n de la résistance de charge de l'étage final symétrique.

6. Circuit selon au moins l'une des revendications 3 à 5, **caractérisé par le fait que** le niveau haut de la sortie de l'étage final symétrique est égal à la tension (V_{ref High}) qui est appliquée à l'entrée non inversée de l'amplificateur opérationnel (OP1) et que le niveau bas de la sortie de l'étage final symétrique est égal à la tension (V_{ref Low}) qui est appliquée à l'entrée non inversée de l'autre amplificateur opérationnel (OP2).

7. Circuit selon au moins l'une des revendications 2 à 6, **caractérisé par le fait que** les éléments d'attaque (TR1, TR2) sont branchés en amont de l'étage final symétrique et fournissent aux transistors (T1, T2, T3, T4) de l'étage final symétrique, en fonction de la tension d'entrée (Vin), les tensions de grille (V_{GHigh}, V_{GLow}) fournies par les amplificateurs opérationnels (TR1, TR2) en coopération avec les moyens de rétroaction ou des tensions dépendantes de celles-ci.

8. Circuit selon au moins l'une des revendications précédentes, **caractérisé par le fait que** les éléments d'attaque (TR1, TR2) sont conçus comme des amplificateurs différentiels.

9. Circuit selon au moins l'une des revendications précédentes, **caractérisé par le fait qu'**une résistance (R3) est branchée entre les sorties (Q, Qn) de l'étage final symétrique.
